# EUROPÄISCHE PATENTANMELDUNG

(11) **EP 1 517 437 A1**
(43) Veröffentlichungstag der Anmeldung: **23.03.2005**
(21) Anmeldenummer: 03021267.4
(22) Anmeldetag: 19.09.2003
(51) Int. Cl.: H03F 1/52, G01R 19/145

(54) **HF-Leistungsverstärker mit Betriebsstrommesseinrichtung**

(71) Anmelder: SIEMENS AKTIENGESELLSCHAFT, 80333 München (DE)
(72) Erfinder: Herzberg, Ralf, 47918 Tönlsvorst (DE); Nagel, Jörg, 47799 Krefeld (DE)

(57) **Zusammenfassung**

Bei einem HF-Leistungsverstärker mit einer Messeinrichtung zum Messen seines Betriebsstroms, wird die Aufgabe, ein Stromversorgungssystem eines Gerätes, das den HF-Leistungsverstärker enthält, gering zu belasten, dadurch gelöst, dass der HF-Leistungsverstärker in einen Hauptverstärker und einen kleiner skalierten Messverstärker aufgeteilt ist, der Hauptverstärker einen ersten Transistor (AMP1) aufweist, an dessen Basis ein zu verstärkendes HF-Nutzsignal anliegt und dessen Arbeitspunkt über eine Vorspannung (Vbias1) eingestellt ist, der Messverstärker einen zweiten Transistor (AMP2) aufweist, an dessen Basis das zu verstärkende HF-Nutzsignal anliegt und dessen Emitter über einen Messwiderstand (Rshunt) zum Erzeugen einer den Betriebsstrom des HF-Leistungsverstärkers wiedergebenden Messspannung (Vm) an Masse liegt, Mittel vorgesehen sind, um zur Einstellung eines Arbeitspunktes des zweiten Transistors (AMP2) eine Vorspannung (Vbias2) des zweiten Transistors (AMP2) an die Vorspannung (Vbias1) des ersten Transistors (AMP1) anzupassen und eine Last (2) mit dem Kollektor des ersten Transistors (AMP1) und mit dem Kollektor des zweiten Transistors (AMP2) verbunden ist.

## Beschreibung

Die Erfindung bezieht sich auf einen HF-Leistungsverstärker mit einer Messeinrichtung zum Messen seines Betriebsstroms sowie auf eine Kombination aus einem solchen HF-Leistungsverstärker mit einer Auswerteeinheit, die gemessene Betriebsströme des HF-Leistungsverstärkers zu dessen Steuerung weiterverarbeitet.

Bekannte Hochfrequenz-(HF-) Leistungsverstärker, die an wechselnden Lasten wie beispielsweise Antennen eingesetzt werden, können durch bestimme Lastzustände unerwünschte Effekte hervorrufen. Dabei sind Lasten besonders problematisch, die zu hohen Betriebsströmen des HF-Leistungsverstärkers führen. Solche hohen Betriebsströme können nämlich den HF-Leistungsverstärker selbst schädigen oder die für den HF-Leistungsverstärker zur Verfügung gestellte Stromversorgung überfordern. Gerade die Problematik einer Überforderung einer bereitgestellten Stromversorgung ist im Anwendungsbereich der Mobilfunkendgeräte besonders ausgeprägt. Denn die Leistungsfähigkeit der bei Mobilfunkendgeräten vorgesehenen Stromversorgungen ist eingeschränkt, während die Sendeantennen von Mobilfunkendgeräten unter stark wechselnden Leistungsbedingungen arbeiten müssen.

Daher wird gerade bei Mobilfunkendgeräten eine Messung des aktuellen Betriebsstroms des HF-Leistungsverstärkers vorgenommen. Dazu wird ein bekannter Messwiderstand in eine Betriebsstromzuführung des HF-Leistungsverstärkers eingeschleift. Eine über den Messwiderstand abfallende Messspannung gibt einen aktuellen Wert für den Betriebsstrom des HF-Leistungsverstärkers wieder.

Ein solcher Messwert wird an eine Auswerteeinheit weitergegeben, in der beispielsweise ein Schwellwert für einen kritischen Betriebsstrom hinterlegt ist und die ein Überschreiten dieses kritischen Betriebsstroms feststellt und daraufhin in eine Steuerung des HF-Leistungsverstärkers eingreift.

Ein Nachteil dieser bekannten Lösung besteht darin, dass der Betriebsstrom für den HF-Leistungsverstärker zwingend durch den Messwiderstand fließt, so dass es nicht zu verhindern ist, dass in dem Messwiderstand eine Verlustleistung auftritt. Diese Verlustleistung schmälert den Wirkungsgrad des HF-Leistungsverstärkers und damit auch des Gesamt-Energieversorgungssystems eines Mobilfunkendgerätes.

Außerdem ist zu berücksichtigen, dass gerade bei Anwendungen für das Mobilfunkendgerät, bei denen mit niedrigen Betriebsspannungen gearbeitet wird, eine Verminderung des Wirkungsgrades erheblich sein kann, da der Anteil der im Messwiderstand entstehenden Verlustleistung relativ groß ist, andererseits aber zur Einhaltung einer erforderlichen Messgenauigkeit die Messspannung nicht beliebig klein gewählt werden kann.

Ausgehend hiervon liegt der Erfindung die Aufgabe zugrunde, einen HF-Leistungsverstärker sowie eine Kombination aus dem HF-Leistungsverstärker und einer Auswerteeinheit anzugeben, bei denen das Stromversorgungssystem eines Gerätes gering belastet wird.

Diese Aufgabe wird bei dem eingangs genannten HF-Leistungsverstärker dadurch gelöst, dass der HF-Leistungsverstärker in einen Hauptverstärker und einen kleiner skalierten Messverstärker aufgeteilt ist, der Hauptverstärker einen ersten Transistor aufweist, an dessen Basis ein zu verstärkendes HF-Nutzsignal anliegt und dessen Arbeitspunkt über eine Vorspannung eingestellt ist, der Messverstärker einen zweiten Transistor aufweist, an dessen Basis das zu verstärkende HF-Nutzsignal anliegt und dessen Emitter über einen Messwiderstand zum Erzeugen einer den Betriebsstrom des HF-Leistungsverstärkers wiedergebenden Messspannung an Masse liegt, Mittel vorgesehen sind, um zur Einstellung eines Arbeitspunktes des zweiten Transistors eine Vorspannung des zweiten Transistors an die Vorspannung des ersten Transistors anzupassen und eine Last mit dem Kollektor des ersten und mit dem Kollektor des zweiten Transistors verbunden ist.

Bei einem solchen HF-Leistungsverstärker wird gewährleistet, dass eine galvanische Ankopplung des zweiten Transistors an eine tatsächlich vorhandene Last wie eine Mobilfunkantenne erfolgt. Außerdem wird sichergestellt, dass sowohl der erste als auch der zweite Transistor hinsichtlich seines Arbeitspunktes auf seiner Kennlinie im wesentlichen gleich eingestellt sind. Dies wird dadurch erreicht, dass der aufgrund des Messwiderstandes auftretende Spannungsunterschied zwischen dem Emitter des Messverstärkers und dem Emitter des Hauptverstärkers durch eine geeignete Wahl der Basisvorspannung des zweiten Transistors ausgeglichen wird.

Die gewonnene Messspannung, die über dem Messwiderstand abfällt, kann zum Bestimmen eines Betriebsstromes des HF-Leistungsverstärkers herangezogen werden. Denn ein Betriebsstrom des ersten Transistors unterscheidet sich von dem Betriebsstrom des zweiten Transistors im wesentlichen durch den gewählten Skalierungsfaktor zwischen Hauptverstärker und Messverstärker. Auf diese Weise wird erreicht, dass eine am Messwiderstand auftretende Verlustleistung gegenüber dem oben dargestellten Stand der Technik wesentlich vermindert wird. Die Kleinerskalierung des Messverstärkers bewirkt, dass die durch den Messwiderstand verursachten Verluste ein Gesamt-Stromversorgungssystem beispielsweise eines Mobilfunkendgerätes nur geringfügig beeinflussen.

Darüber hinaus zeichnet sich der HF-Leistungsverstärker durch eine besondere Einfachheit seiner Schaltung aus. Zur Klarstellung ist hervorzuheben, dass der dargestellte HF-Leistungsverstärker allgemein im Hochfrequenzbereich eingesetzt werden kann und keinesfalls auf eine Anwendung bei Mobilfunkendgeräten beschränkt ist.

Bei einem bevorzugten Ausführungsbeispiel umfassen die Mittel zum Anpassen des Arbeitspunktes des zweiten Transistors einen Addierer, an dessen einem Eingang die Vorspannung des ersten Transistors und an dessen anderem Eingang die Messspannung anliegt, wobei eine Ausgangsspannung des Addierers zur Einstellung des Arbeitspunktes des zweiten Transistors an der Basis dieses Transistors anliegt. Dies bedeutet, dass auf die Vorspannung für den ersten Transistor die Messspannung addiert wird, die mit Hilfe des Messwiderstandes gewonnen wird. Damit wird der Spannungsunterschied zwischen dem Emitter des ersten Transistors und dem Emitter des zweiten Transistors, der sich aufgrund des eingesetzten Messwiderstandes ergibt, ausgeglichen.

Zum Gewinnen eines Gleichspannungssignals für das Messsignal, das mit Hilfe des Messwiderstandes gewonnen wird, kann bevorzugt ein Tiefpass zum Herausfiltern einer Betriebsfrequenz des HF-Leistungsverstärkers aus der Messspannung vorgesehen sein.

Die oben genannte Aufgabe wird hinsichtlich der Kombination aus einem HF-Leistungsverstärker und einer Auswerteeinheit für das Messsignal durch die Merkmale des Anspruchs 4 gelöst. Dabei kann die Auswerteeinheit im wesentlichen so beschaffen sein wie die Auswerteeinheit, die bei der Darstellung des Standes der Technik beschrieben wurde. Sobald der Betriebsstrom des zweiten Transistors einen vorgegebenen Schwellwert überschreitet, erfolgt eine geeignete Steuerung des HF-Leistungsverstärkers zum Vermeiden seiner Schädigung.

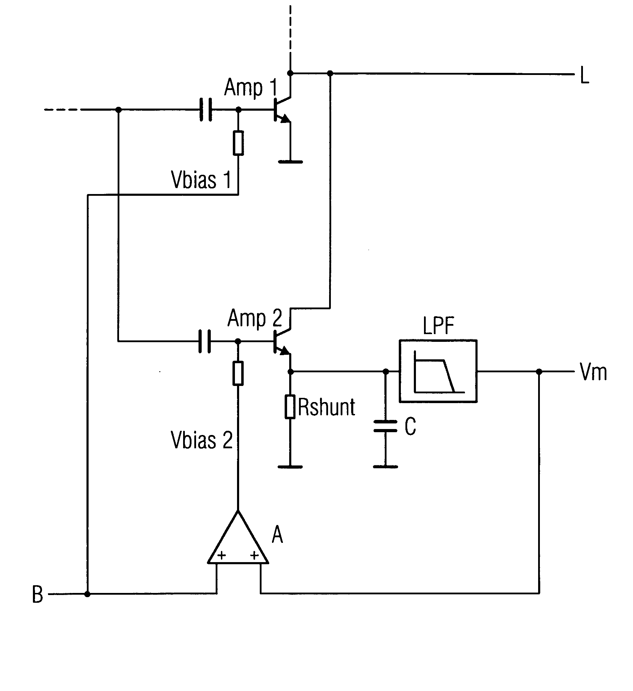

Ein Ausführungsbeispiel der Erfindung wird nachfolgend anhand der einzigen Zeichnung noch näher erläutert, die ein Schaltungsdiagramm eines HF-Leistungsverstärkers zeigt.

Der in der Figur dargestellte HF-Leistungsverstärker dient zur Verstärkung eines Nutzsignals V_{N}, bei dem es sich um ein Hochfrequenzsignal handelt, das beispielsweise in einem Mobilfunkendgerät über eine Antenne auszustrahlen ist. Eine solche Antenne ist ein Beispiel für eine mit dem HF-Leistungsverstärker verbundene Last L.

Das Nutzsignal V_{N} wird über jeweilige Kondensatoren einem ersten Transistor Amp1 eines Hauptverstärkers und einem zweiten Transistor Amp2 eines Messverstärkers zugeführt. Dass Nutzsignal V_{N} liegt im einzelnen an'einer jeweiligen Basis des ersten Transistors Amp1 und des zweiten Transistors Amp2 an. Der erste Transistor Amp1 und der zweite Transistor Amp2 sind in der Zeichnung als Bipolar-Transistoren dargestellt. Es ist jedoch ebenso möglich, diese Transistoren Amp1, Amp2 als MOS-FET-Transistoren auszuführen.

Ein jeweiliger Kollektor K des ersten Transistors Amp1 und des zweiten Transistors Amp2 sind mit der Last L verbunden.

Der den zweiten Transistor Amp2 aufweisende Messverstärker ist kleiner skaliert als der Hauptverstärker, dessen wesentliches Bauelement der Transistor Amp1 ist. Dies bedeutet, dass der erste und der zweite Transistor Amp1, Amp2 in ihren Eigenschaften im wesentlichen gleich sind und sich nur durch ihre skalierten Betriebsströme unterscheiden.

Ein Betriebsstrom des zweiten Transistors Amp2 durchfließt einen Messwiderstand Rshunt, der im dargelegten Ausführungsbeispiel zwischen den Emitter des zweiten Transistors Amp2 und Masse geschaltet ist. An dem Widerstand Rshunt fällt eine Messspannung ab, die über einen Tiefpass LPF derart gefiltert wird, dass ein Betriebsfrequenzsignal des HF-Leistungsverstärkers aus der über den Messwiderstand Rshunt abfallenden Messspannung herausgefiltert wird. Zur Unterdrückung eines Wechselspannungsanteils dient außerdem ein Kondensator C, der zu dem Messwiderstand Rshunt parallel an Masse geschaltet ist. Der Kondensator C wirkt außerdem einer Gegenkopplung entgegen. Hinter dem Tiefpass LPF liegt eine Messspannung Vₘ vor, die einen Betriebsstrom des zweiten Transistors Amp2 und über den Skalierungsfaktor zu dem ersten Transistor Amp1 auch einen Betriebsstrom des ersten Transistors Amp1 wiedergibt. Der Kondensator C und der Tiefpass LPF bewirken gemeinsam, dass die Messspannung Vₘ im wesentlichen eine Gleichspannung ist.

Zur Einstellung von Arbeitspunkten für den ersten Transistor Amp1 und den zweiten Transistor Amp2 dienen jeweilige Vor- bzw. Biasspannungen Vbias1, Vbias2, wobei die Vorspannung Vbias1 für den ersten Transistor Amp1 einer bereitgestellten Vorspannung B entspricht.

Die Vorspannung B liegt außerdem an einem Eingang eines Addierers A an, dessen zweitem Eingang die Messspannung Vₘ zugeführt wird. Am Ausgang des Addierers A liegt die Vorspannung Vbias2 vor, deren Spannungswert somit dem Additionsergebnis aus der Vorspannung B und der Messspannung Vₘ entspricht.

Die Vorspannung Vbias2 für den zweiten Transistor Amp2 überschreitet die Vorspannung Vbias1 für den ersten Transistor somit um die Messspannung Vₘ. Auf diese Weise wird gewährleistet, dass die jeweiligen Emitter des ersten Transistors Amp1 und des zweiten Transistors Amp2 auf demselben Potential liegen. Damit ergeben sich in dem Hauptverstärker und in dem Messverstärker jeweils gleiche Zustände bezüglich einer Ansteuerung ihrer zugehörigen Transistoren, nämlich dem ersten Transistor Amp1 und dem zweiten Transistor Amp2. Der erste Transistor Amp1 und der zweite Transistor Amp2 arbeiten somit näherungsweise unter gleichen Bedingungen, wobei sich die jeweils fließenden Betriebsströme nur durch den Skalierungsfaktor zwischen dem ersten Transistor Amp1 und dem zweiten Transistor Amp2 unterscheiden.

Die Messspannung Vₘ wird derart gewonnen, dass für den Hauptverstärker keine zusätzlichen Verluste eingebracht werden. Die kleinere Skalierung des Messverstärkers in bezug auf den Hauptverstärker bewirkt, dass die durch den Messwiederstand Rshunt verursachten Verluste ein Gesamt-Energieversorgungssystem nur geringfügig beeinflussen. Durch die einfache Anordnung der für eine Realisierung des HF-Leistungsverstärkers erforderlichen elektronischen Komponenten kann die Schaltung besonders in Sendeverstärkern von Mobilfunkendgeräten eingesetzt werden.

Zur Steuerung des HF-Leistungsverstärkers, insbesondere zu seinem Schutz vor zu hohen Betriebsströmen, wird die Messspannung Vₘ in einer (nicht dargestellten) Auswerteeinheit weiterverarbeitet, die bei Überschreiten eines voreingestellten Stellwertes für die Messspannung Vₘ eine geeignete Steuerung für den HF-Leistungsverstärker auslöst.

## Patentansprüche

1. HF-Leistungsverstärker mit einer Messeinrichtung zum Messen seines Betriebsstroms,
**dadurch gekennzeichnet, dass**
der HF-Leistungsverstärker in einen Hauptverstärker und einen kleiner skalierten Messverstärker aufgeteilt ist, der Hauptverstärker einen ersten Transistor (AMP1) aufweist, an dessen Basis ein zu verstärkendes HF-Nutzsignal anliegt und dessen Arbeitspunkt über eine Vorspannung (Vbias1) eingestellt ist,
der Messverstärker einen zweiten Transistor (AMP2) aufweist, an dessen Basis das zu verstärkende HF-Nutzsignal anliegt und dessen Emitter über einen Messwiderstand (Rshunt) zum Erzeugen einer den Betriebsstrom des HF-Leistungsverstärkers wiedergebenden Messspannung (Vm) an Masse liegt,
Mittel vorgesehen sind, um zur Einstellung eines Arbeitspunktes des zweiten Transistors (AMP2) eine Vorspannung (Vbias2) des zweiten Transistors (AMP2) an die Vorspannung (Vbias1) des ersten Transistors (AMP1) anzupassen und
eine Last (2) mit dem Kollektor des ersten Transistors (AMP1) und mit dem Kollektor des zweiten Transistors (AMP2) verbunden ist.

2. HF-Leistungsverstärker nach Anspruch 1,
**dadurch gekennzeichnet, dass**
die Mittel einen Addierer (A) umfassen, an dessen einem Eingang die Vorspannung (Vbias) und an dessen anderem Eingang die Messspannung (Vm) anliegt, wobei eine Ausgangsspannung (Vbias2) des Addierers zur Einstellung des Arbeitspunktes des zweiten Transistors an der Basis dieses Transistors anliegt.

3. HF-Leistungsverstärker nach Anspruch 1 oder 2,
**dadurch gekennzeichnet, dass**
ein Tiefpass (LPF) zum Herausfiltern einer Betriebsfrequenz des HF-Leistungsverstärkers aus der Messspannung vorgesehen ist.

4. HF-Leistungsverstärker nach einem der Ansprüche 1 bis 3,
**dadurch gekennzeichnet, dass**
der erste Transistor (Amp1) und der zweite Transistor (Amp2) als MOS-FET-Transistoren ausgeführt sind.

5. HF-Leistungsverstärker nach einem der Ansprüche 1 bis 3,
**dadurch gekennzeichnet, dass**
der erste Transistor (Amp1) und der zweite Transistor (Amp2) als Bipolar-Transistoren ausgeführt sind.

6. Kombination aus einem HF-Leistungsverstärker nach einem der Ansprüche 1 bis 5 und einer Auswerteeinheit, die zum Detektieren der Messspannung (Vm) und zum Eingreifen in eine Steuerung des HF-Verstärkers ausgebildet ist.
